(19) Europäisches Patentamt
European Patent Office
Office européen des brevets

(11) EP 4 546 218 A1

(12) EUROPEAN PATENT APPLICATION
published in accordance with Art. 153(4) EPC

(43) Date of publication:
30.04.2025 Bulletin 2025/18

(51) International Patent Classification (IPC):
G06N 3/08 (2023.01)    G01R 31/327 (2006.01)

(21) Application number: 22952206.5

(52) Cooperative Patent Classification (CPC):
G01R 31/327; G06N 3/08

(22) Date of filing: 25.07.2022

(86) International application number:
PCT/CN2022/107686

(87) International publication number:
WO 2024/020739 (01.02.2024 Gazette 2024/05)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Siemens Aktiengesellschaft
80333 München (DE)

(72) Inventors:
• DU, Feng
  Shanghai 200120 (CN)
• MIN, Lingbao
  Shanghai 201601 (CN)
• WU, Jianqiang
  Shanghai 201100 (CN)

(74) Representative: Isarpatent
Patent- und Rechtsanwälte
Barth Hassa Peckmann & Partner mbB
Friedrichstraße 31
80801 München (DE)

(54) TRAINING DATA GENERATION METHOD, MODEL TRAINING METHOD, ELECTRONIC DEVICE, AND MEDIUM

(57) Provided in the embodiments of the present application is a training data generation method, comprising: during each opening/closing process among a plurality of instances of opening and closing of a contact of a circuit breaker, acquiring time-series-based rotation angular displacement data of a spindle of the circuit breaker, converting the time-series-based rotation angular displacement data of the spindle into time-series-based linear displacement data of the contact, so as to obtain first time series data; acquiring a control signal inside the circuit breaker, converting the first time series data from an analog quantity into a digital quantity, so as to obtain second time series data; performing filtering fusion processing in the second time series data by using a preset filtering fusion algorithm, so as to obtain third time series data; according to the control signal inside the circuit breaker, performing calibration on the third time series data, so as to obtain fourth time series data; and according to a preset classification rule, respectively marking a plurality of groups of fourth time series data with corresponding category labels.

Fig. 1

## Description

## Technical field

Embodiments of the present application mainly relate to the field of artificial intelligence, in particular a training data generation method, a model training method, an electronic device and a medium.

## Background art

A switch cabinet is an electrical device, which mainly functions to switch on/off, control and protect electric devices in the process of an electrical system generating electricity, transmitting electricity, distributing electricity and converting electrical energy. A medium voltage switch cabinet is a key component in the field of medium voltage electricity, and the state thereof is crucially important for the safety of a whole power station. If it is necessary to measure the state of a medium voltage switch cabinet, generally a stroke trajectory of a contact of a circuit breaker is measured online, then compared with a standard discrete feature value, and a measurement result is judged manually. However, with such a method, not only is it difficult to accurately measure the stroke trajectory of the contact, but also the judgment result obtained is strongly subjective.

## Summary of the invention

Embodiments of the present application provide a training data generation method, a model training method, an electronic device and a medium; high-quality data of the state of a circuit breaker in a medium voltage switch cabinet is generated to train a neural network model, and the trained neural network model can quickly and accurately predict the state of the circuit breaker.

In a first aspect, a training data generation method is provided, comprising: in each opening/closing process in multiple openings/closings of a contact of a circuit breaker, obtaining time-series-based rotation angular displacement data of a main shaft of the circuit breaker; converting the time-series-based rotation angular displacement data of the main shaft into time-series-based linear displacement data of the contact, to obtain first time series data; obtaining a control signal inside the circuit breaker; converting the first time series data from an analog quantity to a digital quantity, to obtain second time series data; performing filtering fusion processing on the second time series data using a preset filtering fusion algorithm, to obtain third time series data; according to the control signal inside the circuit breaker, calibrating the third time series data, to obtain fourth time series data; and, according to a preset classification rule, respectively marking multiple groups of fourth time series data with corresponding category labels.

In a second aspect, a neural network model training method is provided, comprising: executing the training data generation method provided by the first aspect, to obtain a training dataset containing a preset quantity of training data; and using the training dataset to train a neural network model, to obtain an optimized neural network model, wherein the neural network model comprises: a CNN model or an LSTM model.

In a third aspect, an electronic device is provided, comprising: at least one memory, which is configured to store a computer-readable code; and at least one processor, which is configured to call the computer-readable code, to execute each step in the method provided by the first aspect.

In a fourth aspect, a computer-readable medium is provided, a computer-readable instruction being stored on the computer-readable medium, the computer-readable instruction, when executed by a processor, causing the processor to execute each step in the method provided by the first aspect.

## Brief description of the drawings

The accompanying drawings below are merely intended to illustrate and explain schematically the embodiments of the present application, without limiting the scope thereof. In the drawings:

Fig. 1 is a flowchart of a training data generation method according to an embodiment of the present application;
Fig. 2 is a schematic drawing of an interior structure of a circuit breaker according to an embodiment of the present application;
Fig. 3 is a flowchart of a neural network model training method according to an embodiment of the present application; and
Fig. 4 is a schematic drawing of an electronic apparatus according to an embodiment of the present application.

Key to the drawings

100: training data generation method
101 - 107: method step
20: circuit breaker
21: static contact
22: moving contact
23: main shaft
300: neural network model training method
301 - 302: method step
400: electronic device
401: processor
402: memory

## Particular embodiments

The subject matter described herein is now discussed with reference to exemplary embodiments. It should be understood that these embodiments are discussed purely in order to enable those skilled in the art to better understand and thus implement the subject matter described herein, without limiting the protection scope, applicability or examples expounded in the claims. The functions and arrangement of the elements discussed can be changed without departing from the protection scope of the content of the embodiments of the present application. Various processes or components can be omitted from, replaced in or added to each example as required. For example, the method described may be performed in a different order from that described, and all of the steps may be added, omitted or combined. In addition, features described in relation to some examples may also be combined in other examples.

As used herein, the term "comprises" and variants thereof denote open terms, meaning "including but not limited to". The term "based on" means "at least partly based on". The terms "one embodiment" and "an embodiment" mean "at least one embodiment". The term "another embodiment" means "at least one other embodiment". The terms "first", "second", etc. may denote different or identical objects. Other definitions may be included below, either explicit or implicit. Unless clearly indicated in the context, the definition of a term is the same throughout the specification.

Embodiments of the present application are explained in detail below with reference to the accompanying drawings.

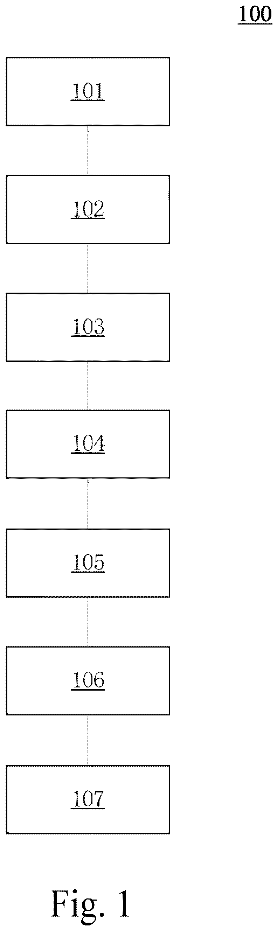

Fig. 1 shows a flowchart of a training data generation method according to an embodiment of the present application; as shown in Fig. 1, the training data generation method 100 comprises:
Step 101, in each opening/closing process in multiple openings/closings of a contact of a circuit breaker, obtaining time-series-based rotation angular displacement data of a main shaft of the circuit breaker.

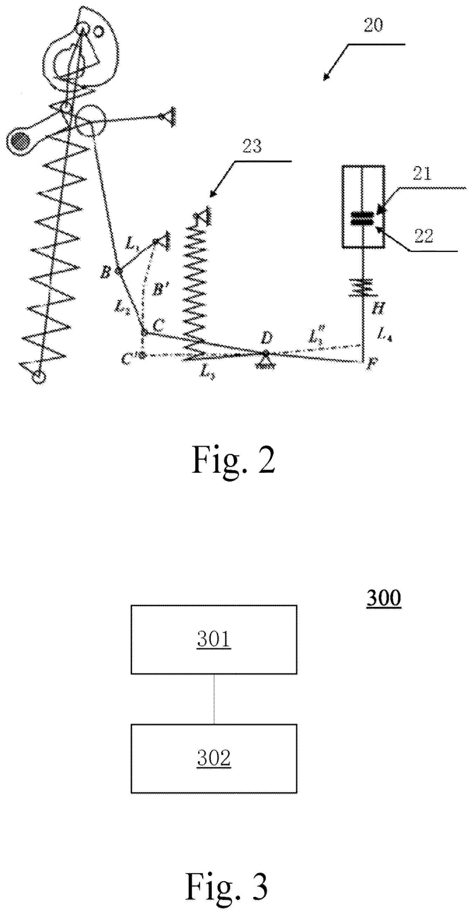

Optionally, time-series-based rotation angular displacement data of a main shaft 23 in a four-bar linkage formed by $L_1$, $L_2$, $L_3$ and $L_4$, as shown in Fig. 2, may be obtained by means of a rotary encoder.

Step 102, converting the time-series-based rotation angular displacement data of the main shaft into time-series-based linear displacement data of the contact, to obtain first time series data.

By means of a calculation on a model of a four-bar linkage in the circuit breaker 20, a model proportionality constant k is obtained, and the time-series-based angular displacement data $\varphi$ of the main shaft 23 is converted into time-series-based linear displacement data f of the contact, wherein $$f = k * \sin\frac{\varphi}{2}$$. The contact is composed of a static contact 21 and a moving contact 22 in Fig. 2, wherein "static contact" refers to a contact that does not follow an action of execution mechanism, whereas the moving contact does follow the action of the execution mechanism.

Optionally, first time series data may be stored in an array form, or first time series data is stored in a curve form. The storage form determines the predictable data form of the final trained neural network model.

Step 103, obtaining a control signal inside the circuit breaker.

The control signal inside the circuit breaker comprises: a current signal of a tripping and closing coil and a signal controlling opening and closing of the contact. The tripping and closing coil is a control element in a circuit control loop, and a tripping and closing coil current is specifically a coil current of an electromagnetic mechanism for driving tripping and closing actions of the circuit breaker.

Step 104, converting the first time series data from an analog quantity to a digital quantity, to obtain second time series data.

Step 105, performing filtering fusion processing on the second time series data using a preset filtering fusion algorithm, to obtain third time series data.

The preset filtering fusion algorithm may be: a Kalman filtering algorithm or a particle filtering algorithm. Using a relevant filtering fusion algorithm may reduce model estimation errors, such as errors of related parameters leading to errors of the function *f,* and related measurement errors.

Step 106, according to the control signal inside the circuit breaker, calibrating the third time series data, to obtain fourth time series data.

The third time series data may be calibrated by means of the signal controlling opening and closing of the contact; specifically, at a moment when the signal controlling opening and closing of the contact is 0, the corresponding third time series data is cleared. The third time series data may also be calibrated by means of the tripping and closing coil current signal, for example deleting a relevant abnormal value, aligning the relevant time series data, etc.

Step 107, according to a preset classification rule, respectively marking multiple groups of fourth time series data with corresponding category labels.

According to a preset classification rule, the multiple groups of fourth time series data are divided at least into two types. The first type of fourth time series data is marked with a first sample label; and the second type of fourth time series data is marked with a second sample label. In one embodiment, a positive sample and a negative sample may be partitioned according to a preset number of disconnections; for example, data of the first 1000 trigger events acts as the positive sample and is marked with a "normal" label, then data of the latter 1000 trigger events acts as the negative sample and is marked with an "abnormal" label. In one embodiment, a relevant sample with an average moving speed, disconnection time or bounce interval that exceeds a preset range may act as a negative sample, and otherwise is a positive sample. In one embodiment, multiple groups of fourth time series data may be divided into multiple types according to an aging process; for example, data of the first 500 trigger events is marked with a 50% aging label, data of trigger events 500 - 1000 is marked with a 70% aging label, and data of trigger events 1000 - 1500 is marked with a 90% trigger label, etc.

By means of embodiments of the present application, time-series-based rotation angular displacement data of a main shaft is converted into time-series-based linear displacement data of a contact, and then by means of relevant filtering fusion and relevant calibration, and further by marking relevant data with category labels, state data that is of high quality and closer to real values may be generated for training a neural network model.

Fig. 3 is a flowchart of a neural network model training method according to an embodiment of the present application; as shown in Fig. 3, the neural network model training method 300 comprises:

Step 301, executing the training data generation method 100, to obtain a training dataset containing a preset quantity of training data.

Step 302, using the training dataset to train a neural network model, to obtain an optimized neural network model, wherein the neural network model comprises: a CNN model or an LSTM model.

In one embodiment, time-series-based data of a contact in each opening/closing process of multiple openings/closings of a circuit breaker online is input to an optimized neural network model, and the optimized neural network model may be used for predicting a corresponding label, such as normal or abnormal.

The trained neural network model of embodiments of the present application can quickly and accurately predict the state of a circuit breaker in a medium voltage switch cabinet, so as to intelligently monitor and protect the medium voltage switch cabinet.

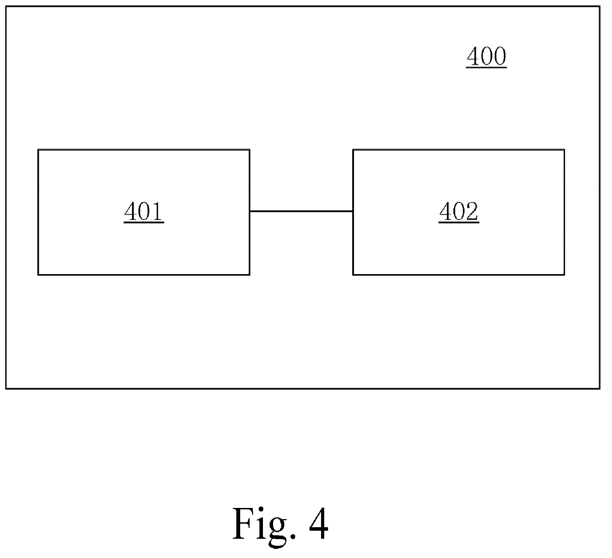

Embodiments of the present application further provide an electronic device 400. Fig. 4 is a schematic drawing of a device control platform 400 according to an embodiment of the present application. As shown in Fig. 4, the device control platform 400 comprises a processor 401 and a memory 402, an instruction being stored in the memory 402, wherein the instruction, when executed by the processor 401, implements the method 100 described above.

At least one processor 401 may comprise a microprocessor, an application specific integrated circuit (ASIC), a digital signal processor (DSP), a central processing unit (CPU), a graphics processing unit (GPU), a state machine, etc. Embodiments of computer-readable media include, but are not limited to, floppy disks, CD-ROM, magnetic disks, memory chips, ROM, RAM, ASIC, configured processors, all-optical media, all magnetic tapes or other magnetic media, or any other media from which instructions can be read by a computer processor. In addition, various other forms of computer-readable media may send or carry instructions to a computer, including a router, dedicated or public network, or other wired and wireless transmission devices or channels. The instructions may include code in any computer programming language, including C, C++, C language, Visual Basic, Java and JavaScript.

In addition, a computer-readable medium is also provided in embodiments of the present application; a computer-readable instruction is stored on the computer-readable medium, and the computer-readable instruction, when executed by a processor, causes the processor to perform the training data generation method described above. Embodiments of computer-readable media include floppy disks, hard disks, magneto-optical disks, optical disks (such as CD-ROM, CD-R, CD-RW, DVD-ROM, DVD-RAM, DVD-RW, DVD+RW), magnetic tapes, non-volatile memory cards and ROM. Optionally, a computer-readable instruction may be downloaded from a server computer or a cloud through a communication network.

It must be explained that not all of the steps and modules in the flows and system structure diagrams above are necessary; certain steps or modules may be omitted according to actual requirements. The sequence in which the steps are executed is not fixed, and may be adjusted as needed. The system structures described in the embodiments above may be physical structures or logical structures, i.e., some modules might be realized by the same physical entity, or some modules might be realized by a plurality of physical entities, or realized jointly by certain components in a plurality of independent devices.

## Claims

1. A training data generation method, **characterized by** comprising:

   - in each opening/closing process in multiple openings/closings of a contact of a circuit breaker, obtaining (101) time-series-based rotation angular displacement data of a main shaft of the circuit breaker;
   - converting (102) the time-series-based rotation angular displacement data of the main shaft into time-series-based linear displacement data of the contact, to obtain first time series data;
   - obtaining (103) a control signal inside the circuit breaker;
   - converting (104) the first time series data from an analog quantity to a digital quantity, to obtain second time series data;
   - performing filtering fusion processing (105) on the second time series data using a preset filtering fusion algorithm, to obtain third time series data;
   - according to the control signal inside the circuit breaker, calibrating (106) the third time series data, to obtain fourth time series data; and
- according to a preset classification rule, respectively marking (107) multiple groups of fourth time series data with corresponding category labels.

2. The method as claimed in claim 1, **characterized in that** the step of, according to a preset classification rule, respectively marking (107) multiple groups of fourth time series data with corresponding category labels comprises:

   - according to a preset classification rule, dividing multiple groups of fourth time series data at least into two types;
   - marking the first type of fourth time series data with a first sample label; and
   - marking the second type of fourth time series data with a second sample label.

3. The method as claimed in claim 1, **characterized in that** the step of obtaining (103) a control signal inside the circuit breaker comprises:

   - obtaining a current signal of a tripping and closing coil; and
   - obtaining a signal controlling opening and closing of a contact.

4. The method as claimed in claim 1, **characterized in that** the preset filtering fusion algorithm comprises: a Kalman filtering algorithm or a particle filtering algorithm.

5. The method as claimed in claim 1, **characterized in that** the step of converting (102) the time-series-based rotation angular displacement data of the main shaft into time-series-based linear displacement data of the contact comprises:

   - by means of a calculation on a four-bar linkage model in the circuit breaker, obtaining a model proportionality constant k, and converting the time-series-based angular displacement data $\varphi$ of the main shaft into time-series-based linear displacement data $f$ of the contact, wherein

   $$f = k * \sin\frac{\varphi}{2}$$
   .

6. The method as claimed in claim 1, **characterized in that** the step of obtaining first time series data comprises:

   - obtaining first time series data stored in an array form; or
   - obtaining first time series data stored in a curve form.

7. A neural network model training method, **characterized by** comprising:

   - executing (301) the training data generation method as claimed in any one of claims 1 to 6, to obtain a training dataset containing a preset quantity of training data; and
   - using (302) the training dataset to train a neural network model, to obtain an optimized neural network model, wherein the neural network model comprises: a CNN model or an LSTM model.

8. An electronic device, comprising a processor (401) and a memory (402), a computer-readable instruction being stored on the memory (402), and the computer-readable instruction, when executed by the processor (401), implementing the method as claimed in any one of claims 1 - 7.

9. A computer-readable storage medium, on which a computer-readable instruction is stored, the computer-readable instruction, when run, executing the method as claimed in any one of claims 1 - 7.

100

```
┌─────────────────┐
│      101        │
└─────────────────┘
         │
┌─────────────────┐
│      102        │
└─────────────────┘
         │
┌─────────────────┐
│      103        │
└─────────────────┘
         │
┌─────────────────┐
│      104        │
└─────────────────┘
         │
┌─────────────────┐
│      105        │
└─────────────────┘
         │
┌─────────────────┐
│      106        │
└─────────────────┘
         │
┌─────────────────┐
│      107        │
└─────────────────┘
```

Fig. 1

20

23

21

22

$L_1$

B

B'

$L_2$

C

C'

$L_5$

D

$L_3''$

$L_4$

H

F

# Fig. 2

300

301

302

# Fig. 3

400

401

402

Fig. 4

<table>
<tr><td colspan="2" align="center">**INTERNATIONAL SEARCH REPORT**</td><td>International application No.<br>**PCT/CN2022/107686**</td></tr>
</table>

**A. CLASSIFICATION OF SUBJECT MATTER**

G06N 3/08(2023.01)i;G01R 31/327(2006.01)i

According to International Patent Classification (IPC) or to both national classification and IPC

**B. FIELDS SEARCHED**

Minimum documentation searched (classification system followed by classification symbols)

IPC: G06N; G01R

Documentation searched other than minimum documentation to the extent that such documents are included in the fields searched

Electronic data base consulted during the international search (name of data base and, where practicable, search terms used)

CNTXT, DWPI, ENTXTC, ENTXT, CNKI: 触头, 断路器, 分类, 角位移, 开关, 粒子滤波, 模拟, 模型, 曲线, 时间, 时间序列, 数字, 位移, 线圈电流, 校准, 训练, 直线位移, 中压, 主轴, 转换, contact, breaker, classification, angular displacement, switch, particle filter, analog, model, curve, time, time series, digital, displacement, coil current, calibration, training, linear displacement, medium voltage, principal axis, conversion

**C. DOCUMENTS CONSIDERED TO BE RELEVANT**

| Category* | Citation of document, with indication, where appropriate, of the relevant passages | Relevant to claim No. |
|---|---|---|
| X | CN 112924861 A (TRAINING CENTER OF STATE GRID NINGXIA ELECTRIC POWER CO., LTD.) 08 June 2021 (2021-06-08)<br>description, paragraphs 35-85 | 1-9 |
| Y | CN 114545217 A (ABB SCHWEIZ AG) 27 May 2022 (2022-05-27)<br>description, paragraphs 50-107 | 1-9 |
| Y | CN 103323770 A (STATE GRID CORPORATION OF CHINA et al.) 25 September 2013 (2013-09-25)<br>description, paragraphs 39-102 | 1-9 |
| Y | CN 114509664 A (ABB SCHWEIZ AG) 17 May 2022 (2022-05-17)<br>description, paragraphs 44-121 | 1-9 |
| A | US 2018059186 A1 (YANG QIBEI) 01 March 2018 (2018-03-01)<br>entire document | 1-9 |

☐ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 March 2023** | **04 April 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

<div align="center">

**INTERNATIONAL SEARCH REPORT**
**Information on patent family members**

</div>

| | | | International application No. |
|---|---|---|---|
| | | | **PCT/CN2022/107686** |

| Patent document cited in search report | | | Publication date (day/month/year) | Patent family member(s) | | | Publication date (day/month/year) |
|---|---|---|---|---|---|---|---|
| CN | 112924861 | A | 08 June 2021 | None | | | |
| CN | 114545217 | A | 27 May 2022 | EP | 4002022 | A1 | 25 May 2022 |
| | | | | US | 2022165526 | A1 | 26 May 2022 |
| CN | 103323770 | A | 25 September 2013 | None | | | |
| CN | 114509664 | A | 17 May 2022 | EP | 4002021 | A1 | 25 May 2022 |
| | | | | US | 2022156586 | A1 | 19 May 2022 |
| US | 2018059186 | A1 | 01 March 2018 | US | 10539618 | B2 | 21 January 2020 |
| | | | | CN | 107884707 | A | 06 April 2018 |
| | | | | CN | 107884707 | B | 21 December 2018 |

Form PCT/ISA/210 (patent family annex) (July 2022)